# EUROPÄISCHE PATENTSCHRIFT

(11) **EP 1 834 079 B1**
(45) Veröffentlichungstag und Bekanntmachung des Hinweises auf die Patenterteilung: **10.11.2010**
(21) Anmeldenummer: 05816154.8
(22) Anmeldetag: 25.11.2005
(51) Int. Cl.: F02M 51/06, F02M 47/02, H01L 41/053

(54) **STELLANTRIEB ZUR BETÄTIGUNG EINES KRAFTSTOFFEINSPRITZVENTILS**
ACTUATOR FOR ACTUATING A FUEL INJECTION VALVE
SERVOMOTEUR POUR L'ACTIONNEMENT D'UNE SOUPAPE D'INJECTION DE CARBURANT

(30) Priorität: 07.01.2005 DE 102005001005
(43) Veröffentlichungstag der Anmeldung: 19.09.2007
(73) Patentinhaber: Continental Automotive GmbH, 30165 Hannover (DE)
(72) Erfinder: BOHLMANN, Tim, 93197 Zeitlarn (DE); KOHN, Stefan, 92277 Hohenburg (DE); PLECHER, Klaus, 93197 Zeitlarn (DE); DENZLER, Michael, 93055 Regensburg (DE); VOIGT, Andreas, 93133 Burglengenfeld (DE); ZUMSTRULL, Claus, 93128 Regenstauf (DE)
(86) Internationale Anmeldenummer: PCT/EP2005/056239
(87) Internationale Veröffentlichungsnummer: WO 2006/072509

(56) Entgegenhaltungen:
- EP-A- 0 987 428
- DE-A1- 10 217 594
- DE-A1- 19 912 666
- DE-A1- 19 925 102
- US-A- 5 875 764

## Beschreibung

Die vorliegende Erfindung betrifft einen Stellantrieb zur Betätigung eines Kraftstoffeinspritzventils nach dem Oberbegriff des Anspruchs 1, insbesondere zur Verwendung als Komponente eines Kraftstoffinjektors einer Brennkraftmaschine.

Ein derartiger Stellantrieb ist beispielsweise aus der DE 198 58 085 C1 bekannt und umfasst einen länglichen piezoelektrischen Aktor, dessen bei Ansteuerung resultierende Längenänderung in Axialrichtung auf ein hydraulisches Servoventil eines Kraftstoffinjektors übertragen wird. Hierzu steht eine Bodenplatte des Piezoaktors über einen Hebelübersetzer mit einem axial geführten Ventilkolben des Servoventils in Wirkverbindung. Die vom Piezoaktor mittels des Hebelübersetzers auf den Ventilkolben übertragene Bewegung wird im Kraftstoffinjektor zum Öffnen und Schließen eines Kraftstoff-Einspritzventils genutzt.

Ein wesentlicher Vorteil der Verwendung eines mittels eines piezoelektrischen Aktors betätigten Servoeinspritzventils ist es, dass mit einem vergleichsweise kleinen Hub (im µm-Bereich) des Piezoaktors ein davon unabhängiger, in der Regel um ein Vielfaches größerer Hub des Einspritzventilkörpers erzielt werden kann (Hydraulische Hubübersetzung). Zudem ergibt sich hierbei der Vorteil, dass die Bewegung des Einspritzventilkörpers zum Öffnen und Schließen der Einspritzpassage durch den Druck des Kraftstoffs getrieben wird, der zu Zwecken der Einspritzung in die Brennkammer ohnehin unter vergleichsweise großem Druck stehend im Bereich des Einspritzventils bereitsteht. Für die Ansteuerung des Einspritzventils genügt daher ein Aktor mit vergleichsweise geringem Hub und vergleichsweise geringer Aktorkraft.

Derartige Stellantriebe besitzen jedoch eine begrenzte Lebensdauer. Es hat sich herausgestellt, dass diese Lebensdauer von der Installationsumgebung des Stellantriebs abhängt. Insbesondere ist anzunehmen, dass bei Vorhandensein von Kraftstoff wie Diesel oder Benzin oder Schmierstoffen wie dem Motoröl einer Brennkraftmaschine in der Installationsumgebung die Lebensdauer auf Grund eines Eindringens dieser "schädlichen" Medien in den Gehäuseinnenraum verkürzt wird.

Die zum Prioritätstag nicht veröffentlichte Druckschrift EP 1 628 015 A1 beschreibt eine Abdichtungsanordnung zur Abdichtung eines Piezoaktors eines Kraftstoffinjektors einer Brennkraftmaschine mit einem Träger, an welchem ein dichtendes Material angeordnet ist, das an Umfangsflächen der Anschlussstifte und an einem Umfangsbereich der Kopfanordnung dichtend anliegt, und an welchem ein aus mikroporösem material gebildetes Teil zur Schaffung einer gaspermeabilität integriert ist.

Dementsprechend ist es eine Aufgabe der vorliegenden Erfindung, einen Stellantrieb der eingangs genannten Art hinsichtlich seiner Lebensdauer zu verbessern.

Diese Aufgabe wird gelöst mit einem Stellantrieb nach Anspruch 1. Die abhängigen Ansprüche betreffen vorteilhafte Weiterbildungen der Erfindung.

Bei dem erfindungsgemäßen Stellantrieb ist vorgesehen, dass die Aktorgehäuseanordnung in dem mit der Kunststoffumspritzung ummantelten Bereich mit einer Belüftungsöffnung versehen ist, in welcher ein aus mikroporösem Material gebildetes Belüftungselement angeordnet ist. Damit wird eine durch die Aktorgehäuseanordnung hindurch verlaufende Belüftungspassage geschaffen, über welche ein druckausgleichender Gasaustausch zwischen dem Aktorgehäuseinnenraum (Aktorraum) und der Außenseite des Stellantriebs (Installationsumgebung bzw. Atmosphäre) ermöglicht wird.

Bei internen betrieblichen Versuchen der Anmelderin hat sich überraschenderweise herausgestellt, dass die Anordnung eines piezokeramischen Bauteils wie dem hier interessierenden Piezoaktor in einem "möglichst hermetisch" abgedichteten Gehäuse in einer schädliche Medien aufweisenden Installationsumgebung die Lebensdauer des Bauteils in der Praxis nicht verlängert sondern tendenziell sogar eher verkürzt.

Demgegenüber führt die erfindungsgemäße Schaffung einer Druck ausgleichenden Gasaustauschverbindung zwischen dem Gehäuseinnenraum und der Atmosphäre zu einer erheblichen Verlängerung der Lebensdauer.

Der Wirkmechanismus der Erfindung ist nicht ganz klar. Eine mögliche Erklärung besteht darin, dass bei einem möglichst hermetisch abgedichteten Gehäuse unter bestimmten Betriebsbedingungen ein Unterdruck im Gehäuseinnenraum entsteht (z. B. durch Temperaturschwankungen), durch welchen schädliche Medien durch die in der Praxis nicht absolut hermetisch auszubildende Abdichtung hindurch in den Gehäuseinnenraum gelangen können. Andere mögliche Erklärungen bestehen beispielsweise darin, dass sich nach der Fertigung eines hermetisch abgeschlossenen Stellantriebs die Konzentration irgendeines die Lebensdauer verkürzenden Gases im Gehäuseinnenraum erhöht bzw. dass eine der atmosphärischen Luft ähnelnde Füllung des Gehäuseinnenraums eine positive Wirkung auf die Lebensdauer besitzt.

In einer Ausführungsform ist vorgesehen, dass in dem hülsenförmigen Aktorgehäuse angeordnet ist:
- eine in Axialrichtung festgelegte und mit Durchtrittsöffnungen zum Durchtritt von Kontaktstiften des Piezoaktors versehene Kopfplatte, an welcher sich ein erstes Ende des Piezoaktors abstützt,
- der in Axialrichtung wirkende Piezoaktor, und
- eine in Axialrichtung bewegbar geführte Bodenplatte, an welcher sich ein zweites Ende des Piezoaktors axial abstützt und welche in Wirkverbindung mit einem Stellglied des Kraftstoffeinspritzventils bringbar ist.

Die Kopfplatte kann hierbei an einem axialen Ende des hülsenförmigen Gehäuses eingesetzt und mit diesem verschweißt oder verstemmt sein. Innerhalb des Aktorraums zwischen der Kopfplatte und der Bodenplatte kann der Piezoaktor unter axialer Druckvorspannung in einer axial langgestreckten Rohrfeder gehalten sein, die zu ihren beiden Enden mit der Kopfplatte und der Bodenplatte verschweißt ist. Die Bodenplatte kann als Teil einer zu einem Stellglied des Kraftstoffeinspritzventils hin wirkenden Wirkverbindung ausgebildet sein. In diesem Bereich kann die Abdichtung des Aktorraums in an sich bekannter Weise durch eine zwischen der Innenwandung des hülsenförmigen Gehäuses und der Bodenplatte eingeschweißten Membran erfolgen.

Bevorzug ummantelt die Kunststoffumspritzung nicht nur bereichsweise das hülsenförmige Aktorgehäuse sondern überdeckt diese, bevorzugt einstückig zusammenhängend, auch ein anschlussseitiges Ende der Aktorgehäuseanordnung.

Mit einer solchen an sich bekannten Kunststoffumspritzung kann beispielsweise das Gehäuse eines zum elektrischen Anschluss des Stellantriebs verwendbaren Steckverbinders bereitgestellt werden.

Wenn die Belüftungsöffnung über deren Länge betrachtet eine variierende Öffnungsfläche besitzt, also beispielsweise eine Verjüngung und/oder eine oder mehrere Stufen, so kann dies insbesondere von Vorteil für die Montage bzw. eine Verpressung des Belüftungselements bzw. eines Verbunds aus dem Belüftungselement und einem Trägerteil sein. In einer besonders bevorzugten Ausführungsform ist vorgesehen, dass die Öffnungsfläche der Belüftungsöffnung sich an einem Übergang vom Aktorgehäuse zur Kunststoffumspritzung sprunghaft vergrößert. Der damit gebildete Absatz innerhalb der Belüftungsöffnung lässt sich vorteilhaft als Anlagefläche für das Belüftungselement bzw. für weitere Komponenten nutzen, die von der Außenseite der Aktorgehäuseanordnung in die Belüftungsöffnung einzufügen sind. Bei diesen weiteren Komponenten kann es sich beispielsweise um einen nachfolgend noch beschriebenen Dichtring oder einen nachfolgend noch beschriebenen Belüftungselementträger handeln.

Bevorzugt ist in der Belüftungsöffnung wenigstens ein Dichtring zur ringförmig umlaufenden Abdichtung einer durch das Zentrum der Belüftungsöffnung und das Belüftungselement hindurchgehenden Belüftungspassage angeordnet. Ein solcher Dichtring kann beispielsweise einerseits an dem Material des hülsenförmigen Aktorgehäuses und andererseits an dem Belüftungselement oder einem dichtend damit verbundenen Belüftungselementträger dichtend anliegen.

Wenn die oben erwähnte sprunghafte Vergrößerung der Öffnungsfläche am Übergang vom Aktorgehäuse zur Kunststoffumspritzung vorgesehen ist, so kann der im Bereich der Kunststoffumspritzung durch den größeren Öffnungsdurchmesser geschaffene Raum zur Aufnahme eines solchen Dichtrings genutzt werden, der dann dichtend an der äußeren Mantelfläche des hülsenförmigen Aktorgehäuses anliegen kann. Andererseits kann dieser Dichtring dann an dem Belüftungselement bzw. einem damit dichtend verbundenen Belüftungselementträger dichtend anliegen.

Bevorzugt ist der Dichtring in der Belüftungsöffnung verpresst, etwa um dessen Dichtwirkung zu verbessern.

In einer Ausführungsform ist vorgesehen, dass das Belüftungselement ringförmig umlaufend mit einem hülsenförmigen Belüftungselementträger verbunden ist. Eine unmittelbare und dichtende Verbindung lässt sich hierbei beispielsweise durch eine Verschweißung oder Verklebung erreichen. Die Verwendung eines Belüftungselementträgers besitzt zwei wesentliche Vorteile: Zum einen kann damit eine mechanische Belastung des Belüftungselements vermindert oder vermieden werden, was insbesondere bei einem mechanisch empfindlichen und/oder vergleichsweise klein bzw. dünn dimensionierten Belüftungselement bedeutsam ist. Zum anderen können damit die Materialien für das Belüftungselement und für den Belüftungselementträger unabhängig voneinander und somit für ihre jeweilige Funktion optimiert gewählt werden.

Bevorzugt ist das Belüftungselement aus ePTFE (expandiertes Polytetrafluorethylen) gebildet. Dieses Material hat sich als sehr vorteilhaft herausgestellt, um damit "schädliche Medien" wie Kraftstoff (Diesel, Benzin, etc.) oder Schmierstoffe (z. B. Motoröl) am Eindringen in den Aktorraum zu hindern und gleichzeitig flüchtige Stoffe aus dem Aktorraum heraus und Luft bzw. Sauerstoff in den Aktorraum hinein defundieren zu lassen. Andere hier verwendbare mikroporöse Materialien sind dem Fachmann wohlbekannt und bedürfen daher keiner weiteren Erläuterung.

Das Belüftungselement kann z. B. im Wesentlichen scheibenförmig (z. B. als Membran) ausgebildet sein. Eine derartige Belüftungsscheibe bzw. -Membran kann beispielsweise durch eine ringsherum abdichtende Presspassung in die Belüftungsöffnung eingefügt sein. Alternativ kann das Belüftungselement ringförmig umlaufend mit einem hülsenförmigen Belüftungselementträger verbunden sein, dessen Außenumfang dichtend am Innenumfang der Belüftungsöffnung anliegt.

Eine bevorzugte Verwendung des erfindungsgemäßen Stellantriebs ergibt sich für den Piezoaktors eines Kraftstoffinjektors einer Brennkraftmaschine, bei welcher der Kraftstoffinjektor und wenigstens eine weitere Komponente einer Kraftstoffeinspritzeinrichtung im Wesentlichen vollständig innerhalb einer Motorblockbaugruppe der Brennkraftmaschine angeordnet sind. Damit ist insbesondere der Fall gemeint, in welchem Komponenten der Einspritzeinrichtung innerhalb der Motorblockbaugruppe untergebracht sind, die ohne Einschränkung ihrer Funktion auch außerhalb derselben angeordnet werden könnten. Der Begriff "Motorblockbaugruppe" bezeichnet hierbei die Gesamtheit der Motorschmieröle enthaltenden Komponenten, also den "Motorblock" im engeren Sinne und Anbauteile (wie z. B. einen Zylinderkopfdeckel etc.), in denen das Schmieröl gepumpt wird oder schmiert oder (zurück)geführt wird. Bei einer solchen Motorkonstruktion besteht eine erhöhte Gefahr eines Eintrags von "schädlichen Medien" wie Öl und/oder Kraftstoff in den Innenraum eines Injektorgehäuses bzw. in den Aktorraum. Diese Problematik ergibt sich z. B. insbesondere für Dieselmotoren mit Speichereinspritzsystem (z. B. "common rail") mit innerhalb des Zylinderkopfdeckels liegenden Einspritzkomponenten. Eine ähnliche Problematik, nämlich die Gefahr eines Eintrags von Wasser, ergibt sich auch bei einer außerhalb einer Motorblockbaugruppe angeordneten Einspritzeinrichtung, z. B. bei Geländefahrzeugen, deren Motor kurzfristig teilweise oder ganz unter Wasser betrieben werden muss.

Die Erfindung wird nachfolgend anhand eines Ausführungsbeispiels mit Bezug auf die beigefügten Zeichnungen näher beschrieben. Es stellen dar:
- Fig. 1: eine Seitenansicht eines Stellantriebs in einem Stadium der Fertigung, bei welchem eine Belüf- tungsöffnung bereits ausgebildet, jedoch noch mit Einbauten zu versehen ist,
- Fig. 2: zeigt den Stellantrieb von Fig. 1 nach dem Ein- setzen eines Dichtrings in die Belüftungsöffnung,
- Fig. 3: zeigt den Stellantrieb gemäß Fig. 2 nach dem Auf- setzen eines Belüftungselementträgers,
- Fig. 4: ist eine Schnittansicht längs der Linie IV/IV in Fig. 5, und
- Fig. 5: zeigt den Stellantrieb gemäß Fig. 3 nach dem Auf- schweißen eines Belüftungselements.

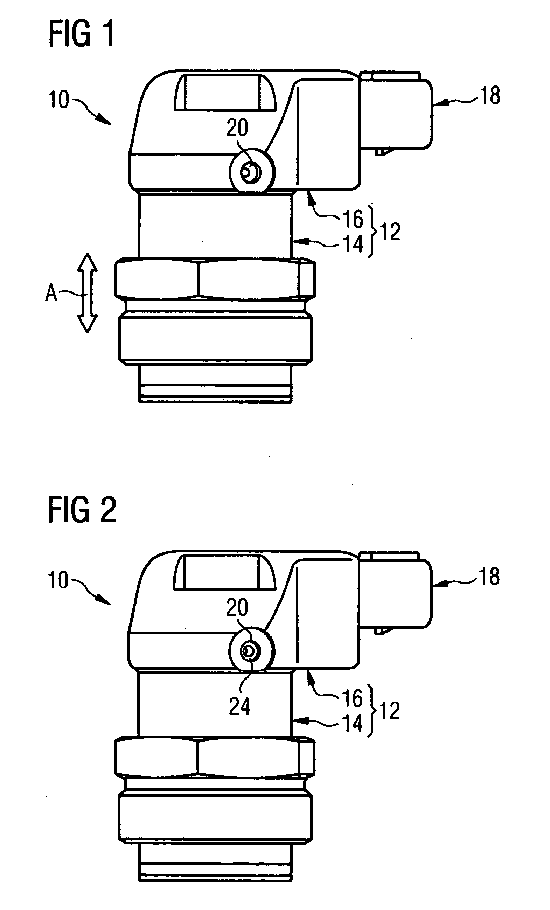

Fig. 1 zeigt einen insgesamt mit 10 bezeichneten Stellantrieb zur Betätigung eines (nicht dargestellten) Kraftstoffeinspritzventils. Der Stellantrieb 10 bildet zusammen mit diesem Kraftstoffeinspritzventil einen Kraftstoffinjektor für eine Brennkraftmaschine und dient zum angesteuerten Öffnen und Schließen des über eine mechanische Wirkverbindung mit dem Stellantrieb verbundenen Einspritzventils im Betrieb der Brennkraftmaschine.

Der Stellantrieb 10 umfasst einen (nicht dargestellten) Piezoaktor, der in einer Aktorgehäuseanordnung 12 eingeschlossen ist, von der in der Figur ein hülsenförmiges, in einer Axialrichtung A langgestrecktes und aus Metall (z. B. Invar) gefertigtes Aktorgehäuse 14 sowie eine Kunststoffumspritzung 16 zu sehen ist.

Die Kunststoffumspritzung 16 ummantelt einen oberen (anschlussseitigen) Bereich des Aktorgehäuses 14 und bildet gleichzeitig ein oberes (anschlussseitiges) Ende der Aktorgehäuseanordnung 12.

In an sich bekannter Weise umhüllt die Kunststoffumspritzung 16 eine am oberen Ende des Aktorgehäuses 14 angeordnete, so genannte Kontaktbaugruppe, mittels welcher zwei durch eine abgedichtete Kopfanordnung hindurch geführte Kontaktstifte des Piezoaktors elektrisch mit zwei Anschlussstiften eines Steckverbinders 18 verbunden sind. Mit dem Steckverbinder 18 kann der Kraftstoffinjektor zur Ansteuerung an eine externe Leitungsanordnung (z. B. Kabelbaum in einem Kraftfahrzeug) angeschlossen werden. Ein in Fig. 1 rechter Abschnitt der Kunststoffumspritzung 16 bildet hierbei ein Gehäuse für den Steckverbinder 18.

Was den inneren Aufbau des Stellantriebs 10 bzw. des damit gebildeten Kraftstoffinjektors anbelangt, so ist dieser Aufbau von an sich bekannter Art und im Rahmen der Erfindung von nebengeordneter Bedeutung. Zum Aufbau von Kraftstoffinjektoren der hier interessierenden Art wird lediglich beispielhaft auf die DE 199 56 256 B4 und die DE 100 07 175 A1 verwiesen. Eine Möglichkeit zur Abdichtung der Kontaktstifte des Piezoaktors ist beispielsweise in der DE 102 51 225 A1 beschrieben. Zur Gestaltung der Kontaktbaugruppe wird ebenfalls lediglich beispielhaft auf die DE 198 44 743 C1 und die DE 199 40 347 A1 verwiesen.

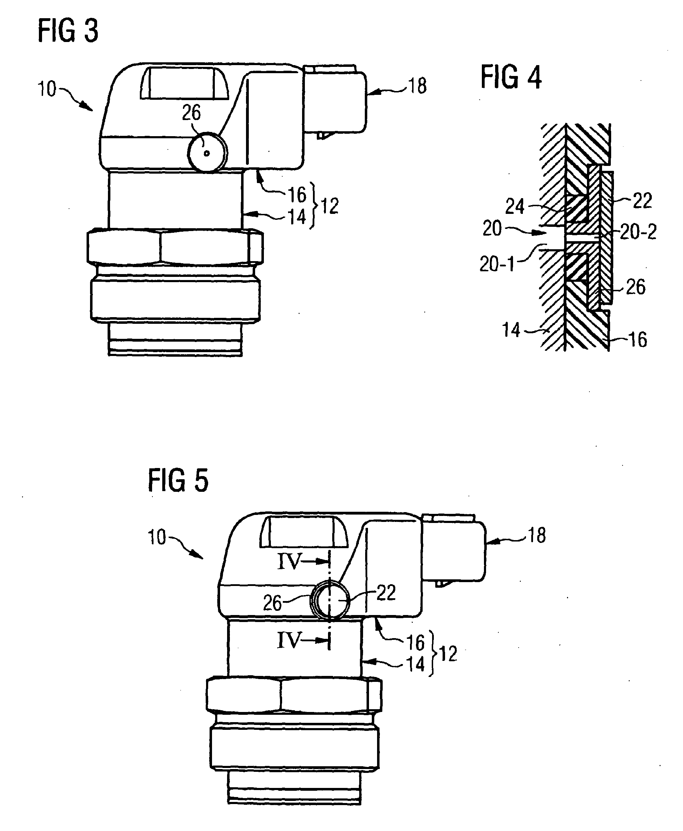

Eine Besonderheit des dargestellten Stellantriebs 10 ist es, dass die Aktorgehäuseanordnung 12 im ummantelten Bereich mit einer Belüftungsöffnung 20 versehen ist, in welcher in nachfolgend noch beschriebener Weise ein aus mikroporösem Material gebildetes Belüftungselement 22 (Fig. 4) integriert wird. Das Belüftungselement dient in Verbindung mit der Belüftungsöffnung 20 dazu, eine von der Außenseite des Stellantriebs 10 in den Aktorraum führende Belüftungspassage zu schaffen, durch welche hindurch ein Gasaustausch stattfinden kann, Flüssigkeiten wie z. B. Motoröl jedoch an einem Vordringen zum Aktorraum gehindert werden.

Das innere Ende der Belüftungsöffnung 20 mündet unmittelbar im zur Aufnahme des Piezoaktors vorgesehenen Aktorraum des Stellantriebs 10.

Die Anordnung bzw. Integration des Belüftungselements 22 bei der Stellantriebsmontage wird nachfolgend anhand der Fig. 2 bis 5 erläutert.

Aus der Schnittdarstellung nach Fig. 4 ist ersichtlich, dass die Öffnungsfläche der Belüftungsöffnung 20 sich an einem Übergang vom Aktorgehäuse 14 zur Kunststoffumspritzung 16 sprunghaft vergrößert. Im Bereich des metallischen Aktorgehäuses 14 ist die Belüftungsöffnung 20 als Bohrung 20-1 mit einheitlichem, vergleichsweise kleinem Durchmesser ausgebildet, wohingegen im Bereich der Kunststoffumspritzung 16 die Belüftungsöffnung 20 als eine Stufenbohrung 20-2 mit vergleichsweise großen Durchmessern ausgebildet ist, bei welcher sich der Bohrungsdurchmesser nach außen hin nochmals sprunghaft vergrößert.

Ausgehend von der in Fig. 1 dargestellten Situation wird zunächst ein Dichtring 24 aus Elastomer von außen in die Belüftungsöffnung 20 eingesetzt, so dass dieser in den Abschnitt mit kleinerem Durchmesser der Stufenbohrung 20-2 aufgenommen und an einer äußeren Mantelfläche des Aktorgehäuses 14 um die äußere Mündung der Bohrung 20-1 herum zur Anlage kommt (vgl. Fig. 4).

Sodann wird ein hülsenförmiger und aus Kunststoff gebildeter Belüftungselementträger 26 in die Belüftungsöffnung 20 eingesetzt und an seinem Rand umlaufend mit der Kunststoffumspritzung 16 verschweißt. Diese Situation nach dem Einsetzen des Belüftungselementträgers 26 ist in Fig. 3 dargestellt. Der Belüftungselementträger 26 besitzt einen scheibenartigen Abschnitt sowie einen sich daran anschließenden zylindrischen Abschnitt und ist, wie in Fig. 4 ersichtlich, mit dem zylindrischen Abschnitt voran in die Belüftungsöffnung 20 derart eingesetzt, dass ein Außenumfang des zylindrischen Abschnitts dichtend zur Anlage an einem Innenumfang des Dichtrings 24 kommt.

Abschließend wird das als scheibenförmige ePTFE-Membran ausgebildete Belüftungselement 22 auf die äußere Flachseite des Belüftungselementträgers 26 aufgesetzt und an seinem Rand umlaufend mit dem Belüftungselementträger 26 verschweißt. Die Situation nach Anbringung des Belüftungselements 22 ist in den Fig. 4 und 5 dargestellt.

Bevorzugt und abweichend vom dargestellten Ausführungsbeispiel wird eine vorgefertigte Baueinheit aus Belüftungselement und Belüftungselementträger vorgefertigt und als Ganzes in die Belüftungsöffnung eingesetzt.

Im fertiggestellten Zustand nach Fig. 4 und 5 verläuft eine durch das Zentrum der Belüftungsöffnung 20 und das Belüftungselement 22 hindurchgehende Belüftungspassage, die durch den Dichtring 24 und die Verschweißung zwischen dem Belüftungselement 22 und dem Belüftungselementträger 26 ringförmig umlaufend abgedichtet ist. Der mit dem Kunststoffmaterial durch eine Verschweißung (oder z. B. Verklebung) verbundene Belüftungselementträger 26 drückt hierbei den Dichtring 24 gegen die Außenseite des Aktorgehäuses 14, so dass der Dichtring 24 zwischen dem Aktorgehäuse 14 und dem Belüftungselementträger 26 eingeklemmt ist. Dadurch kommt es ebenfalls zu einer dichten Anlage des Dichtringmaterials am Außenumfang des zylindrischen Abschnitts und/oder an der inneren Flachseite des scheibenförmigen Abschnitts des Belüftungselementträgers 26. Im dargestellten Ausführungsbeispiel erfolgt die dichtende Anlage des Dichtrings 24 an dem zylindrischen Abschnitt des Belüftungselementträgers 26 bereits durch eine geeignet bemessene Presspassung zwischen Dichtring 24 und Belüftungselementträger 26, die durch die Druckbelastung lediglich noch verstärkt wird.

Abweichend vom dargestellten Ausführungsbeispiel ist es denkbar, mehrere Belüftungsöffnungen mit jeweils einem darin integrierten Belüftungselement vorzusehen. Auch sind Modifikationen an den in der Belüftungsöffnung eingesetzten Komponenten denkbar. Beispielsweise könnte ein Belüftungselement zwischen zwei Dichtringen der beschriebenen Art eingeklemmt sein oder könnte die Verbindung zwischen dem Belüftungselementträger und der Kunststoffumspritzung durch eine Verrastung realisiert sein.

## Patentansprüche

1. Stellantrieb zur Betätigung eines Kraftstoffeinspritzventils, umfassend einen Piezoaktor, der in einer Aktorgehäuseanordnung (12) eingeschlossen ist, die ein hülsenförmiges, in einer Axialrichtung (A) langgestrecktes und wenigstens bereichsweise mit einer Kunststoffumspritzung (16) ummanteltes Aktorgehäuse (14) aufweist, **dadurch**
**gekennzeichnet, dass** die Aktorgehäuseanordnung (12) im ummantelten Bereich mit einer Belüftungsöffnung (20) versehen ist, in welcher ein aus mikroporösem Material gebildetes Belüftungselement (22) angeordnet ist.

2. Stellantrieb nach Anspruch 1, wobei in dem hülsenförmigen Aktorgehäuse (14) angeordnet ist:
- eine in Axialrichtung (A) festgelegte und mit Durchtrittsöffnungen zum Durchtritt von Kontaktstiften des Piezoaktors versehene Kopfplatte, an welcher sich ein erstes Ende des Piezoaktors abstützt,
- der in Axialrichtung wirkende Piezoaktor, und
- eine in Axialrichtung bewegbar geführte Bodenplatte, an welcher sich ein zweites Ende des Piezoaktors axial abstützt und welche in Wirkverbindung mit einem Stellglied des Kraftstoffeinspritzventils bringbar ist.

3. Stellantrieb nach einem der vorangehenden Ansprüche, wobei die Kunststoffumspritzung (16) ein anschlussseitiges Ende der Aktorgehäuseanordnung (12) überdeckt oder ausbildet.

4. Stellantrieb nach einem der vorangehenden Ansprüche, wobei die Öffnungsfläche der Belüftungsöffnung (20) sich an einem Übergang vom Aktorgehäuse (14) zur Kunststoffumspritzung (16) sprunghaft vergrößert.

5. Stellantrieb nach einem der vorangehenden Ansprüche, wobei in der Belüftungsöffnung (20) wenigstens ein Dichtring (24) zur ringförmig umlaufenden Abdichtung einer durch das Zentrum der Belüftungsöffnung (20) und das Belüftungselement (22) hindurchgehenden Belüftungspassage angeordnet ist.

6. Stellantrieb nach Anspruch 5, wobei der Dichtring (24) in der Belüftungsöffnung (20) verpresst ist.

7. Stellantrieb nach einem der vorangehenden Ansprüche, wobei das Belüftungselement (22) ringförmig umlaufend mit einem hülsenförmigen Belüftungselementträger (26) verbunden ist.

8. Stellantrieb nach einem der vorangehenden Ansprüche, wobei das Belüftungselement (22) aus ePTFE gebildet ist.

## Claims

1. Actuator for actuating a fuel injection valve, comprising a piezoactuator which is enclosed in an actuator housing unit (12) having a cylindrical actuator housing (14) which is elongated in an axial direction (A) and at least partially encased by an extruded plastics material coat (16), **characterised in that** the actuator housing unit (12), in its encased region, is provided with a ventilation aperture (20) in which a ventilation element (22) produced from a microporous material is disposed.

2. Actuator according to claim 1, wherein arranged in the cylindrical actuator housing (14) is:
- a top plate that is fixed in the axial direction (A) and is provided with through-openings for the passage of contact pins of the piezoactuator, on which plate a first end of the piezoactuator is supported,
- the piezoactuator that acts in the axial direction, and
- a base plate that is movably guided in the axial direction and on which a second end of the piezoactuator is axially supported and can be actively connected to an actuator of the fuel injection valve.

3. Actuator according to any one of the preceding claims, wherein the extruded plastics material coat (16) covers or forms a connection-side end of the actuator housing unit (12).

4. Actuator according to any one of the preceding claims, wherein the opening area of the ventilation opening (20) suddenly enlarges at a transition from the actuator housing (14) to the extruded plastics material coat (16).

5. Actuator according to any one of the preceding claims, wherein at least one sealing ring (24) is arranged in the ventilation opening (20) for annular sealing of a ventilation passage that passes through the centre of the ventilation opening (20) and the ventilation element (22).

6. Actuator according to claim 5, wherein the sealing ring (24) is pressed into the ventilation opening (20).

7. Actuator according to any one of the preceding claims, wherein the ventilation element (22) is annularly connected to a cylindrical ventilation element carrier (26).

8. Actuator according to any one of the preceding claims, wherein the ventilation element (22) is produced from ePTFE.

## Revendications

1. Servomoteur pour l'actionnement d'une soupape d'injection de carburant, comportant un actionneur piézoélectrique, qui est enfermé dans un ensemble de boîtier (12), qui comporte un boîtier (14), en forme de manchon, allongé dans la direction axiale (A) et enrobé au moins par zones par une matière plastique surmoulée par injection (16), **caractérisé en ce que** l'ensemble de boîtier (12), dans la zone enrobée, est muni d'une ouverture de ventilation (20) dans laquelle est disposé un élément de ventilation (22) réalisé dans un matériau microporeux.

2. Servomoteur selon la revendication 1, dans lequel dans le boîtier (14) en forme de manchon sont disposés :
- une plaque de tête qui est immobilisée dans la direction axiale (A) et est munie de trous débouchants pour le passage des plots de contact de l'actionneur piézoélectrique et sur laquelle prend appui une première extrémité de l'actionneur piézoélectrique,
- l'actionneur piézoélectrique qui agit dans la direction axiale, et
- une plaque de fond logée mobile dans la direction axiale, sur laquelle prend appui dans le sens axial une deuxième extrémité de l'actionneur piézoélectrique et laquelle peut être amenée en liaison active avec un organe de réglage de la soupape d'injection de carburant.

3. Servomoteur selon l'une quelconque des revendications précédentes, dans lequel la matière plastique surmoulée par injection (16) couvre ou forme une extrémité du côté raccordement de l'ensemble de boîtier (12).

4. Servomoteur selon l'une quelconque des revendications précédentes, dans lequel la surface d'ouverture de l'ouverture de ventilation (20) s'agrandit brusquement au niveau d'une transition entre le boîtier (14) et la matière plastique surmoulée par injection (16).

5. Servomoteur selon l'une quelconque des revendications précédentes, dans lequel dans l'ouverture de ventilation (20) est disposée au moins une bague d'étanchéité (24) qui assure l'étanchéité sur tout le pourtour annulaire d'un passage de ventilation qui traverse le centre de l'ouverture de ventilation (20) et l'élément de ventilation (22).

6. Servomoteur selon la revendication 5, dans lequel la bague d'étanchéité (24) est comprimée dans l'ouverture de ventilation (20).

7. Servomoteur selon l'une quelconque des revendications précédentes, dans lequel l'élément de ventilation (22) est relié de manière annulaire sur le pourtour au support d'élément de ventilation (26) en forme de manchon.

8. Servomoteur selon l'une quelconque des revendications précédentes, dans lequel l'élément de ventilation (22) est réalisé en ePTFE.
